# EUROPEAN PATENT APPLICATION

(11) **EP 1 467 606 A1**
(43) Date of publication of application: **13.10.2004**
(21) Application number: 02796789.2
(22) Date of filing: 13.12.2002
(51) Int. Cl.: H05K 7/20

(54) **INTEGRATED ELECTRONIC BOX**

(30) Priority: 27.12.2001 ES 200103134 U
(71) Applicant: Lear Automotive (EEDS) Spain, S.L., 43800 Valls, Tarragona (ES)
(72) Inventor: FERRAN, Ignasi, 43800 Valls (Tarragona) (ES)
(74) Representative: Primo de Rivera y Urquijo, Jose Antonio
(86) International application number: PCT/ES2002/000596
(87) International publication number: WO 2003/056893

(57) **Abstract**

Integrated electronic container, composed by a rack containing electronic circuits, it presupposes the integration in the previously mentioned structure of a heat sink element and the modular assembly of the remaining components: main connection elements and electronic components, electronic printed boards, and heat dissipation area.

## Description

This invention, integrated electronic container, consists of a new and original design of the structure of the rack containing the electronic circuits which means the integration in the aforementioned structure of a heat sink together with the modular assembly of the remaining components: main connection elements and electronic components, electronic printed boards, and heat dissipation area.

For all these reasons, this invention, an integrated electronic container, will be of particular interest to the sector dealing with the manufacturing and design of electrical and electronic devices, since this container permits the integrated design of the aforementioned devices.

Currently, the State of the Art encompasses a large variety of cabinets for the design of electrical and electronic equipment. The main characteristic of these cabinets is their main structural members that include access doors, hinges, anchorages, etc., as well as other more specific elements such as socket covers, fan supports, trays where the electronic boards are placed, clamps, anti-vibration supports, rolling groups, sealed planes, ventilation planes, anchorage groups, optic fiber boxes, distribution boards, transportation eye bolts, partitions between structural elements, fans, different types of terminal blocks: with switch, with magnetocaloric, terminal block supports, rack supports, windows or inspection holes: made of glass, methacrylate, heat dissipating elements: fans and radiators.

In view of the above, it can be stated that the current state of the art is sufficiently developed to allow the creation of a tight modular design by simply selecting those structural elements required for each particular application. Nevertheless, the final size, assembly time and final design have repercussions on the final cost of the electronic equipment, which forces the search of special designs that can integrate the different structural elements. This is the case of this invention, object of interest, since its novel structure permits the integration of the main elements and electronic components present in the products produced by this sector with the elements that dissipate the heat generated inside the equipment because of the heating up of some of the components, mainly power semiconductor elements.

Also, the structure object of this invention together with the integration of the different structural elements, enables the protection of the electronic circuits against dust, humidity variations, temperature, ultraviolet rays and against bumps and scratches, in addition to improving the aesthetic aspect and operation security.

Therefore, the object of this invention, integrated electronic container, described next is composed by a rack structure for electric and electronic equipment. This structure includes a heat sink and connection elements that are integrated in this invention, becoming part of the aforementioned rack structure. In order to do so, the heat sink elements and connection elements are placed at opposite extremes of the rack structure permitting the easy differentiation between the connections area and the heat dissipation area, allowing access to the first mentioned area without having to wait any time for the equipment to cool off.

On the other hand, inside the rack structure is where the electronic circuits are located, in printed circuit boards, the control as well as the power circuits, equipped with a thermal gel that transmits the heat generated by the electronic components to the heat sink, specially in cases where sealed racks are used.

Normally in these cases the rack structure will be made up of two pieces: a receiving body in whose base the connectors area is located, and a cover where the previously mentioned heat sink is placed. The rack is provided with airtight joints to close between the two rack areas so that the proper air tightness is reached an thus, protect the electronic circuits from exterior agents such as humidity, dust and dirt.

Nevertheless, the sealed rack structure may consist of more than two bodies, each provided with airtight joints, if a functional o assembly advantage of the equipment is obtained.

Next, we will provide a detailed description of the integrated electronic container, object of this invention, with reference to the accompanying diagrams, which shows, a non- exclusive sample, the preferred use. This sample can be adapted to all detail variations that do not presuppose a fundamental alteration of the essential characteristics of these advances.

The diagrams show:

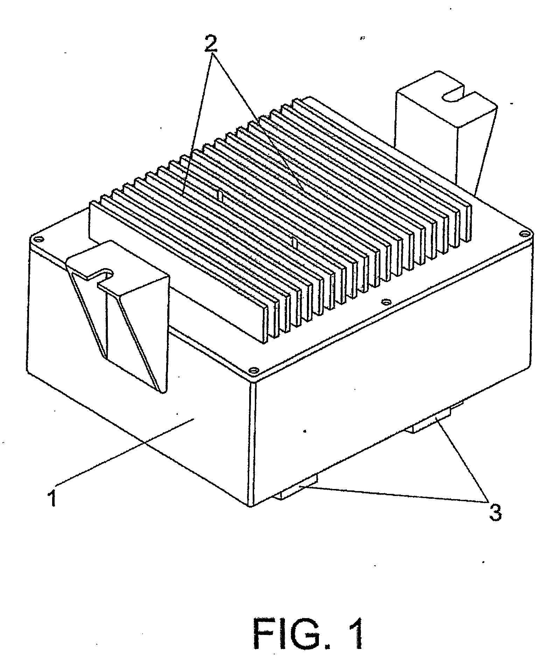

Figure 1: View of an integrated electronic container.

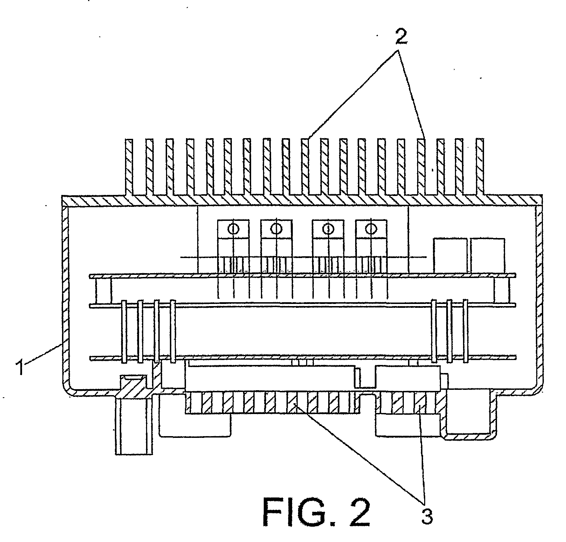

Figure 2: detailed view of the interior section of an integrated electronic container.

In accordance with the preferred embodiment exposed the integrated electronic container is basically composed by a rack structure (1) for electrical and electronic equipment. It includes a heat sink (2) and connection elements (3) and it integrates these functional elements making them part of the mentioned rack structure (1). In order to do so, the heat sink elements (2) and the connection elements (3) are located at opposite extremes of the rack structure permitting the easy differentiation between the connections area and the heat dissipation area, allowing access to the first mentioned area without having to wait any time for the equipment to cool off.

On the other hand, inside the rack structure (1) is where the electronic circuits are located, in printed circuit boards, the control as well as the power circuits, equipped with a thermal gel that transmits the heat generated by the electronic components to the heat sink (2), specially in cases where sealed racks are used.

Normally in these cases the rack structure (1) will be made up of two pieces: a receiving body in whose base the connectors area (3) is located, and a cover where the previously mentioned heat sink (2) is placed. The rack is provided with airtight joints to close the two rack bodies so that the proper air tightness is reached an thus, protect the electronic circuits from exterior agents such as humidity, dust and dirt.

Finally, the shape, materials and dimensions and in general, all accessories and secondary elements that do not alter, change or modify the essential described advances can be modified.

## Claims

1. Integrated electronic container, made of a rack structure (1) for electrical and electronic equipment, comprising a heat sink (2) and connection elements (3), **characterized** because said heat sink (2) as well as the connection elements (3) are integrated becoming part of the previously mentioned rack structure (1), distributed at opposite extremes, being placed the electronic circuits in the interior of the rack structure (1), in printed board boards, with a thermal gel that transmits the heat generated by the electronic components to the heat sink (2).

2. Integrated electronic container, according to claim 1, **characterized** because the mentioned rack structure (1) is airtight, consisting of at least two bodies, a receiving body in which base the connectors are located (3) and a cover where the heat sink is placed (2), being the closure between both bodies of the rack provided with airtight joints.

3. Integrated electronic container, according to any of the preceding claims, **characterized** because the rack structure (1) consists of more than two bodies, being all of them provided with airtight joints.
